# EUROPEAN PATENT APPLICATION

(11) **EP 3 206 394 A1**
(43) Date of publication of application: **16.08.2017**
(21) Application number: 15848763.7
(22) Date of filing: 01.10.2015
(51) Int. Cl.: H04N 7/18, B60R 1/00, B60R 21/00

(54) **ELECTRONIC MIRROR DEVICE**

(30) Priority: 07.10.2014 JP 2014206200
(71) Applicant: Panasonic Intellectual Property Management Co., Ltd., Osaka-shi, Osaka 540-6207 (JP)
(72) Inventor: UCHIMURA, Motonobu, Chuo-ku Osaka-shi Osaka 540-6207 (JP); NAKAI, Wataru, Chuo-ku Osaka-shi Osaka 540-6207 (JP); OKOHIRA, Takashi, Chuo-ku Osaka-shi Osaka 540-6207 (JP)
(74) Representative: Schwabe - Sandmair - Marx
(86) International application number: PCT/JP2015/004999
(87) International publication number: WO 2016/056208

(57) **Abstract**

An electronic mirror device includes a display, a controller that controls the display, a switching portion, and a preliminary starter. The display includes a main case having an opening, a video display portion, and a semi-transparent mirror. The video display portion includes a display screen and displays camera images captured by a camera. The semi-transparent mirror is provided between the display screen of the video display portion and the opening of the main case and displays a mirror reflection. The switching portion causes the display to switch between displaying the camera images and the mirror reflection. The preliminary starter preliminarily starts up the controller and the display before the switching portion causes the display to display the camera images.

## Description

### TECHNICAL FIELD

The present invention relates to an electronic mirror device that is mounted to a vehicle or the like.

### BACKGROUND ART

Conventionally, an electronic mirror device including a semi-transparent mirror on a front surface of a video display portion is known. There are cases where a driver of a vehicle with the electronic mirror device finds it difficult to check behind with a mirror function due to a person, luggage, and the like inside the vehicle blocking his or her rearward view. In such a case, the electronic mirror device displays, on the video display portion, vehicle rearview camera images captured by a camera mounted to the vehicle, and the driver can check behind by watching the camera images (see Patent Literature (PTL) 1, for example).

### Citation List

### Patent Literature

PTL 1: Unexamined Japanese Patent Publication No. H11-291817

### SUMMARY OF THE INVENTION

The present invention provides an electronic mirror device capable of promptly displaying camera images upon switching to the camera images.

An electronic mirror device according to the present invention includes a display, a controller that controls the display, a switching portion, and a preliminary starter. The display includes a main case having an opening, a video display portion, and a semi-transparent mirror. The video display portion includes a display screen and displays camera images captured by a camera. The semi-transparent mirror is located between the display screen of the video display portion and the opening of the main case and displays a mirror reflection. The switching portion causes the display to switch between displaying the camera images and the mirror reflection. The preliminary starter preliminarily starts up the controller and the display before the switching portion causes the display to display the camera images.

The electronic mirror device having the above-described configuration is capable of promptly displaying the camera images upon switching from the mirror reflection to the camera images.

### BRIEF DESCRIPTION OF THE DRAWINGS

FIG. 1 is a front view illustrating an interior of a vehicle to which an electronic mirror device according to an exemplary embodiment of the present invention is mounted.
FIG. 2 is a plan view of the vehicle illustrated in FIG. 1.
FIG. 3 is a side transparent view of the vehicle illustrated in FIG. 1.
FIG. 4 is a front view of a display device according to the exemplary embodiment of the present invention.
FIG. 5A is a cross-sectional view of the display device in FIG. 4 in a mirror mode.
FIG. 5B is a cross-sectional view of the display device in FIG. 4 in a camera-image mode.
FIG. 6 is a block diagram illustrating control of the electronic mirror device according to the exemplary embodiment of the present invention.
FIG. 7 is a flowchart showing an example of operations of the electronic mirror device according to the exemplary embodiment of the present invention.

### DESCRIPTION OF EMBODIMENTS

Prior to the description of an exemplary embodiment of the present invention, a problem with the conventional electronic mirror device will be briefly described. With the conventional electronic mirror device, upon switching from the mirror reflection on the semi-transparent mirror to the camera images, an imaging element of the camera, a video display device, or the like takes time for starting up them. This causes a delay in checking behind by the driver.

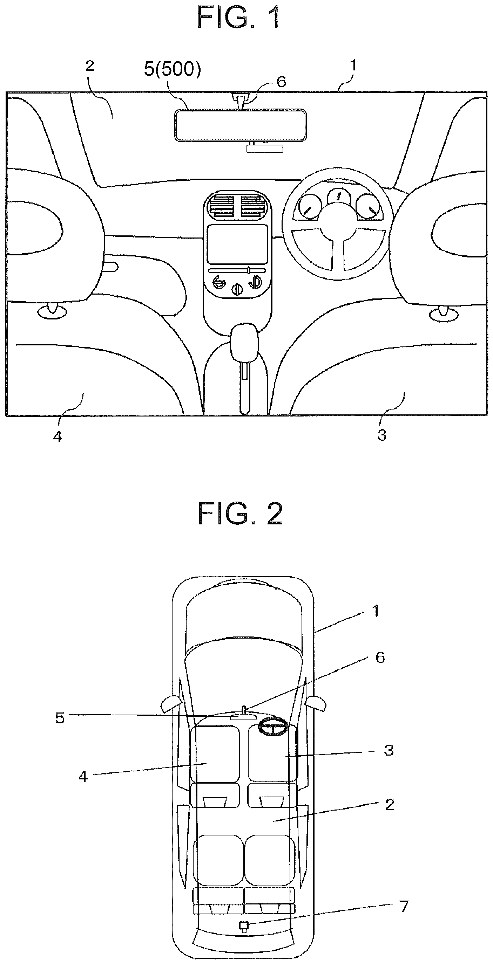

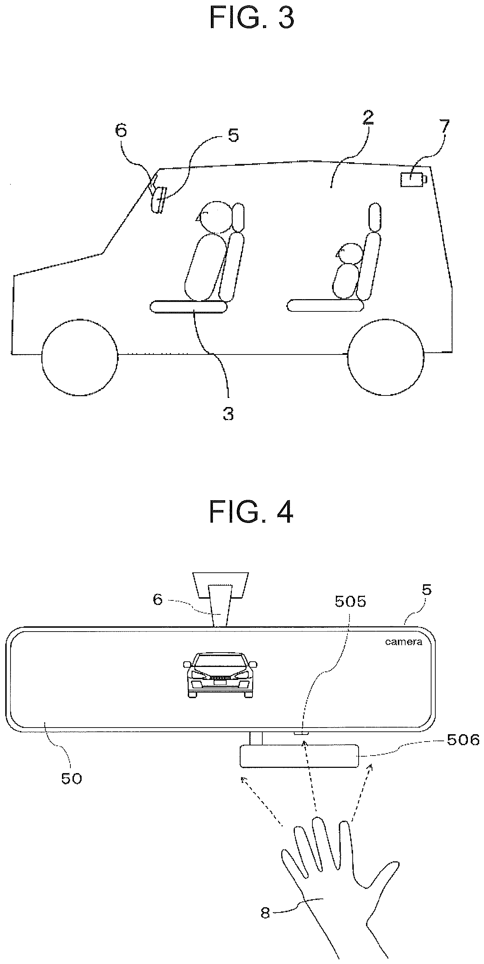

Hereinafter, an electronic mirror device according to the exemplary embodiment of the present invention will be described with reference to the drawings as an example in a case where the electronic mirror device is mounted to a vehicle. FIG. 1 is a front view illustrating an interior of vehicle compartment 2 of vehicle 1 to which the electronic mirror device according to the exemplary embodiment of the present invention is mounted, FIG. 2 is a plan view of vehicle 1, and FIG. 3 is a side transparent view of vehicle 1.

In vehicle 1, in a front area between driver's seat 3 and front passenger's seat 4 in vehicle compartment 2, display 5 which is included in electronic mirror device 500 is attached to attachment 6, at a rearview mirror attachment position in such a manner as to be tiltable for adjustment. Camera 7 that captures vehicle rearview images and transmits image signals to electronic mirror device 500 is attached to the rear of vehicle 1.

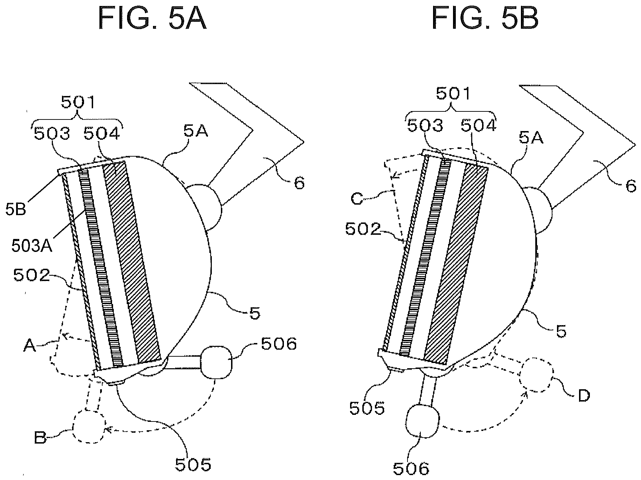

FIG. 4 is a front view of display 5 which is included in electronic mirror device 500, and FIG. 5A and FIG. 5B are cross-sectional views of display 5. Display 5 includes main case 5A, liquid-crystal display 501, and semi-transparent mirror 502. Main case 5A has opening 5B on the driver's seat 3 side. Liquid-crystal display 501 is a video display portion fitted in opening 5B of main case 5A so that a liquid-crystal display screen, which is display screen 503A, is positioned on the driver's seat 3 side. Semi-transparent mirror 502 is provided on the driver's seat 3 side of liquid-crystal display 501. Liquid-crystal display 501 includes liquid-crystal panel 503 and backlight 504 therein. Backlight 504 is provided on the opposite side of liquid-crystal panel 503 from display screen 503A. Display 5 includes infrared sensor 505 and switching lever 506 which is a switching portion. In other words, display 5 includes main case 5A having opening 5B, liquid-crystal display 501, and semi-transparent mirror 502. Liquid-crystal display 501 includes display screen 503A and displays camera images captured by camera 7. Semi-transparent mirror 502 is provided between display screen 503A of liquid-crystal display 501 and opening 5B of main case 5A and displays a mirror reflection. Switching lever 506 causes display 5 to switch between displaying the camera images and the mirror reflection.

Electronic mirror device 500 has a camera-image mode and a mirror mode. In the camera-image mode, liquid-crystal panel 503 is activated, and backlight 504 is turned ON, to display, on display screen 50 of display 5, the camera images captured by camera 7. In the mirror mode, backlight 504 is turned OFF, and the mirror reflection on semi-transparent mirror 502 is displayed on display screen 50.

The camera-image mode and the mirror mode are switched with switching lever 506 as the switching portion. In FIG. 5A, which illustrates a state in the mirror mode, dashed lines A and B represent changes in the position of display 5 and a change in the position of switching lever 506, respectively, upon switching to the camera-image mode. In FIG. 5B, which illustrates a state in the camera-image mode, dashed lines C and D represent changes in the position of display 5 and a change in the position of switching lever 506, respectively, upon switching to the mirror mode.

As illustrated in FIG. 5A, in the mirror mode, switching lever 506 is lifted rearward of display 5, and display screen 50 of display 5 takes a top forward posture. In order to switch from the mirror mode to the camera-image mode, switching lever 506 is turned approximately one-quarter turn downward from behind, and display screen 50 of display 5 is switched from the top forward posture to a top rearward posture.

As illustrated in FIG. 5B, in the camera-image mode, switching lever 506 is moved downward of display 5, and display screen 50 of display 5 takes the top rearward posture. In order to switch from the camera-image mode to the mirror mode, switching lever 506 is turned approximately one-quarter turn rearward from below, and display screen 50 of display 5 is switched from the top rearward posture to the top forwardposture.

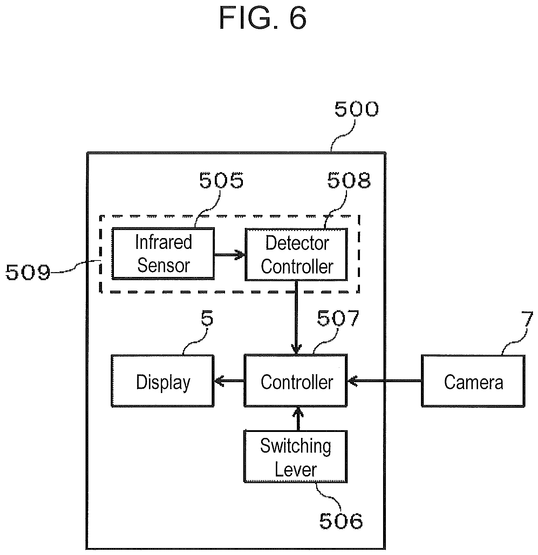

FIG. 6 is a block diagram illustrating control of electronic mirror device 500. Electronic mirror device 500 includes display 5, controller 507, switching lever 506, and preliminary starter 509. Preliminary starter 509 includes infrared sensor 505 and detector controller 508 that is connected to infrared sensor 505 and controls infrared sensor 505. Controller 507 is connected to display 5, camera 7, switching lever 506, and detector controller 508, and controls display 5 and camera 7 and supplies power thereto.

Controller 507 includes: a CPU (Central Processing Unit) that controls operations; a ROM (Read Only Memory) in which a control program is stored; and a RAM (Random Access Memory) in which data to be temporarily held, control data, and the like are stored. Detector controller 508 receives a signal from infrared sensor 505, and when infrared sensor 505 detects body part 8 of an operator, gives controller 507 an instruction for performing a preliminary start-up.

Infrared sensor 505 is a detector that detects an operating movement made by the operator to switch from the mirror mode to the camera-image mode. As illustrated in FIG. 4, when body part 8 of the operator approaches switching lever 506, infrared sensor 505 detects the body of the operator, and preliminary starter 509 performs a preliminary start-up for transition to the camera-image mode. In this manner, infrared sensor 505 covers an area around switching lever 506 as a detection area, and preliminary starter 509 preliminarily starts up controller 507 and display 5 before switching lever 506 causes display 5 to display the camera images. In the preliminary start-up, camera 7 is started up, liquid-crystal display 501 is started up, and the function of controlling camera 7 and liquid-crystal display 501 is started. When switching lever 506 is operated, controller 507 causes backlight 504 to turn ON, and the camera images are promptly displayed on liquid-crystal display 501.

Note that as a result of preliminary starter 509 preliminarily starting up infrared sensor 505 and detector controller 508, electronic mirror device 500 can be preliminarily started up without requiring the operator to perform a separate preliminary start-up operation. Furthermore, the operator can perform the preliminary start-up without needing to remember or be aware of how to perform the preliminary start-up operation. Therefore, electronic mirror device 500 is very user friendly.

Furthermore, since infrared sensor 505 covers the area around switching lever 506 as the detection area, an operating movement of the operator can be easily detected. Therefore, electronic mirror device 500 rarely malfunctions and thus is very user friendly.

Generally, the capacity of a battery power supply mounted on vehicle 1 is limited, and therefore it is necessary to minimize power consumption. For this reason, it is desirable that when electronic mirror device 500 is used in the mirror mode, power supply to liquid-crystal panel 503, backlight 504, camera 7, and controller 507 for driving and controlling these elements be minimized. However, the elements such as liquid-crystal panel 503 and camera 7 need roughly one second to start up, and therefore, upon switching from the mirror mode to the camera-image mode, it would not be possible to promptly display the camera images, which causes a delay in checking behind by the driver. As a countermeasure for this, electronic mirror device 500 performs the preliminary start-up to enable a prompt display of the camera images upon switching from the mirror mode to the camera-image mode.

Display 5 includes liquid-crystal panel 503 and backlight 504, and preliminary starter 509 starts up controller 507, camera 7, and liquid-crystal panel 503 before switching lever 506 causes display 5 to display the camera images. When switching lever 506 is operated, controller 507 causes backlight 504 to turn ON. Thus, electronic mirror device 500 can start up camera 7 and liquid-crystal panel 503, which need time to start up, in advance by the preliminary start-up and therefore, can promptly display the camera images upon a switching operation.

Furthermore, since switching lever 506 is provided to display 5, the operator can intuitively understand the functions of switching lever 506 which is a switching portion that switches between the mirror mode and the camera-image mode. Thus, the operator can easily operate electronic mirror device 500.

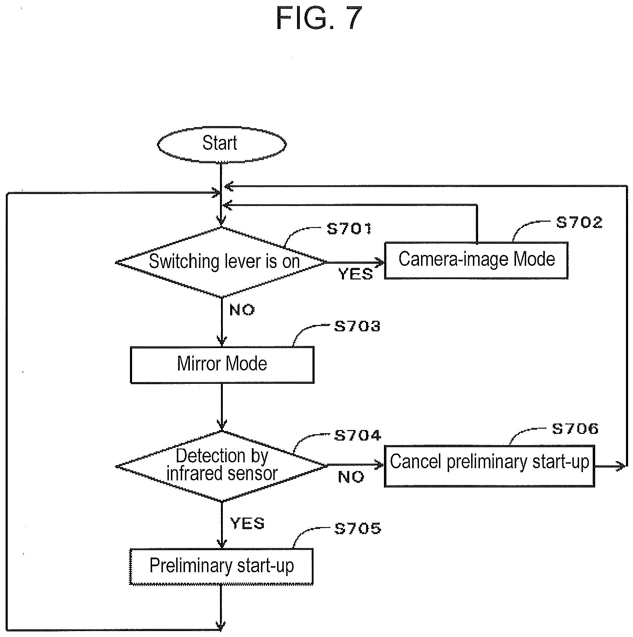

An example of the main operations of electronic mirror device 500 configured as described above will be described. FIG. 7 is a flowchart showing an example of the main operations of electronic mirror device 500.

When the engine of vehicle 1 is started and processing starts, controller 507 of electronic mirror device 500 determines whether switching lever 506 is ON, that is, in the camera-image mode, or switching lever 506 is OFF, that is, in the mirror mode (Step S701).

When switching lever 506 is ON, that is, in the camera-image mode (Step S701: YES), the camera-image mode is started. The camera-image mode then continues while switching lever 506 is in the camera-image mode (Step S702).

When switching lever 506 is OFF, that is, in the mirror mode (Step S701: NO), the mirror mode is maintained while the camera-image mode is not started, or the camera-image mode is ended to transition to the mirror mode (Step S703).

When switching lever 506 is in the mirror mode, detector controller 508 determines whether or not infrared sensor 505 has detected body part 8 of the operator (Step S704).

When infrared sensor 505 has detected body part 8 of the operator (Step S704: YES), electronic mirror device 500 enters a preliminary set-up status (Step S705).

The entry into the preliminary start-up status (Step S705) is followed by a determination status in which whether or not switching lever 506 is switched to the camera-image mode is determined (Step S701), and when switching lever 506 is switched to ON (Step S701: YES), the preliminary start-up status is switched to the camera-image mode (Step S702).

When infrared sensor 505 has not detected body part 8 of the operator (Step S704: NO), the preliminary start-up status is canceled or the status in which the preliminary start-up has not been performed is maintained (Step S706), and the process returns to the determination status for switching lever 506 (Step S701). At this time, even when infrared sensor 505 has failed in detecting body part 8 of the operator, the determination about switching lever 506 is prioritized. That is, when switching lever 506 is switched to ON, a switchover to the camera-image mode occurs (Step S702).

Note that in the case where the preliminary start-up is canceled in the preliminary start-up status (Step S706), a timer may be provided so that the preliminary start-up is canceled, for example, after five seconds.

In the above description, switching lever 506 is provided to display 5. Aside from this installation, preliminary starter 509 and the switching portion for switching from the mirror mode to the camera-image mode may be provided, for example, as a switch installed on a steering wheel or a dashboard. In this case, preliminary starter 509 and the switching portion may be provided as separate switches. Alternatively, preliminary starter 509 and the switching portion may be provided as a single switch, and the mirror mode without the preliminary start-up, the mirror mode with the preliminary start-up, and the camera-image mode may be switched according to a sliding position of the switch, for example.

### INDUSTRIAL APPLICABILITY

An electronic mirror according to the present invention is useful as a rearview checking device that is mounted to a vehicle.

### REFERENCE MARKS IN THE DRAWINGS

- 1: vehicle
- 2: vehicle compartment
- 3: driver's seat
- 4: front passenger's seat
- 5: display
- 6: attachment
- 7: camera
- 8: body part
- 5A: main case
- 5B: opening
- 50, 503A: display screen
- 500: electronic mirror device
- 501: liquid-crystal display
- 502: semi-transparent mirror
- 503: liquid-crystal panel
- 504: backlight
- 505: infrared sensor
- 506: switching lever (switching portion)
- 507: controller
- 508: detector controller
- 509: preliminary starter

## Claims

1. An electronic mirror device comprising:
a display including:
a main case having an opening;
a video display portion that includes a display screen and displays camera images captured by a camera; and
a semi-transparent mirror that is provided between the display screen of the video display portion and the opening of the main case and displays a mirror reflection;
a controller that controls the display;
a switching portion that causes the display to switch between displaying the camera images and the mirror reflection; and
a preliminary starter that preliminarily starts up the controller and the display before the switching portion causes the display to display the camera images.

2. The electronic mirror device according to claim 1,
wherein the preliminary starter includes a detector and a detector controller that controls the detector, and
when the detector detects a movement to operate the switching portion, the controller and the display are preliminarily started up.

3. The electronic mirror device according to claim 2,
wherein the detector is an infrared sensor that covers an area around the switching portion as a detection range.

4. The electronic mirror device according to claim 1,
wherein the video display portion includes a liquid-crystal panel including the display screen, and a backlight provided on an opposite side of the liquid-crystal panel from the display screen,
the preliminary starter starts up the controller, the camera, and the liquid-crystal panel before the switching portion causes the display to display the camera images, and
when the switching portion is operated, the controller causes the backlight to turn ON.

5. The electronic mirror device according to claim 1,
wherein the switching portion is provided to the display.
